# EUROPÄISCHE PATENTSCHRIFT

(11) **EP 0 847 618 B1**
(45) Veröffentlichungstag und Bekanntmachung des Hinweises auf die Patenterteilung: **21.06.2000**
(21) Anmeldenummer: 97906084.5
(22) Anmeldetag: 13.01.1997
(51) Int. Cl.: H03B 9/14

(54) **MIKROWELLENOSZILLATOR**
MICROWAVE OSCILLATOR
OSCILLATEUR A HYPERFREQUENCES

(30) Priorität: 29.06.1996 DE 19626214
(43) Veröffentlichungstag der Anmeldung: 17.06.1998
(73) Patentinhaber: ROBERT BOSCH GMBH, 70442 Stuttgart (DE)
(72) Erfinder: SCHMIDT, Ewald, D-71634 Ludwigsburg (DE); LUCAS, Bernhard, D-74395 Mundelsheim (DE)
(86) Internationale Anmeldenummer: DE9700036
(87) Internationale Veröffentlichungsnummer: WO9800904

(56) Entgegenhaltungen:
- DE-A- 2 826 767
- US-A- 3 878 480
- US-A- 3 913 035
- US-A- 4 048 589
- PATENT ABSTRACTS OF JAPAN vol. 006, no. 200 (E-135), 9.Oktober 1982 & JP 57 109407 A (TOKYO SHIBAURA DENKI KK), 7.Juli 1982,
- IEEE TRANSACTIONS ON MICROWAVE THEORY AND TECHNIQUES, Bd. 43, Nr. 2, 1.Februar 1995, Seiten 344-349, XP000490548 BIALKOWSKI M E: "ANALYSIS OF A COAXIAL-TO-WAVEGUIDE ADAPTOR INCLUDING A DISCENDED 2 PROBE AND A TUNING POST"

## Beschreibung

### Stand der Technik

Die vorliegende Erfindung betrifft einen Mikrowellenoszillator, bestehend aus einem einseitig kurzgeschlossenen Hohlleiter und einer darin angeordneten Diode - vorzugsweise Gunn-Diode -, die ihre Versorgungsspannung über einen durch eine Hohlleiterwand hindurchgeführten Koppelstift erhält, wobei mindestens ein in den Hohlleiter hineinragender, in seiner Eindringtiefe verstellbarer Abgleichstift zum Abstimmen der Oszillatorfrequenz vorgesehen ist.

Ein derartiger Mikrowellenoszillator mit einer Gunn-Diode ist beispielsweise aus der DE-A-28 26 767, der US-A-3 878 480 oder der DE-A 27 09 210 bekannt. Gemäß diesem Stand der Technik ist der Abgleichstift entweder in der Schmalseite oder in der Breitseite des die Gunn-Diode tragenden Hohlleiters angeordnet. In dem einen Fall ist also der Abgleichstift senkrecht und in dem anderen Fall parallel zu dem die Versorgungsspannung an die Gunn-Diode zuführenden Koppelstift ausgerichtet. Üblicherweise ist bei einem solchen Mikrowellenoszillator die Kurzschlußwand des Hohlleiters verschiebbar, womit eine induktiv wirkende Abstimmmöglichkeit für die Oszillatorfrequenz gegeben ist. Diese Abstimmumg wirkt sich hauptsächlich auf die vom Oszillator abgegebene Leistung aus. Der die Versorgungsspannung an die Gunn-Diode zuführende Abgleichstift ist in der Durchführungsöffnung zum Hohlleiter mit einer Sperrfilterstruktur (Choke) versehen, um ein ungewolltes Abfließen eines Teils der Oszillatorleistung durch die Durchführung zu verhindern.

Der Erfindung liegt die Aufgabe zugrunde, einen Mikrowellenoszillator der eingangs genannten Art anzugeben, dessen Frequenzabgleich möglichst einfach durchgeführt werden kann.

### Vorteile der Erfindung

Die Aufgabe wird gemäß Anspruch 1 dadurch gelöst, daß der Abgleichstift unter einem spitzen Winkel auf den die Versorgungsspannung an die Diode zuführenden Koppelstift ausgerichtet ist. Damit wird die Abgleichempfindlichkeit für die Resonanzfrequenz des Oszillators kleiner gegenüber der bekannten parallelen oder senkrechten Ausrichtung des Abgleichstiftes; d.h. die Resonanzfrequenzänderung ist weniger stark abhängig von einer Änderung der Eindringtiefe des Abgleichstiftes in das Feld um die Diode.

Gemäß den Unteransprüchen ist es zweckmäßig, den Koppelstift mit einem Querschnittssprung zu versehen, welcher einen Resonanzkreis bildet, und den Abgleichstift zwischen diesem Querschnittssprung und einer am Koppelstift befindlichen Sperrfilterstruktur auf den Koppelstift auszurichten.

### Beschreibung eines Ausführungsbeispiels

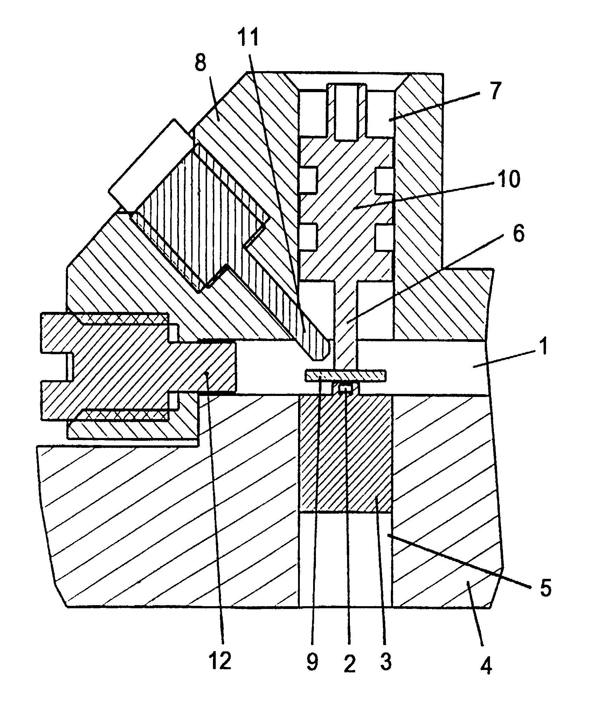

Anhand eines in der Zeichnung dargestellten Ausführungsbeispiels wird nachfolgend die Erfindung näher erläutert.

Der in der Figur dargestellte Mikrowellenoszillator weist einen einseitig kurzgeschlossenen Hohlleiter 1 auf, in dem eine als aktives Oszillatorelement wirkende Diode 2, vorzugsweise eine Gunn-Diode, angeordnet ist. Diese Diode 2 wird von einem als Wärmesenke dienenden Körper 3 gehalten. In einer Wand des Hohlleiters 1 ist eine Öffnung 5 vorgesehen, in welcher der die Diode 2 tragende Körper 3 einsetzbar ist.

Der Diode 2 wird über einen Koppelstift 6 die erforderliche Versorgungsspannung zugeführt. Dieser Koppelstift 6 ragt durch eine Durchführung 7 in der der Diode 2 gegenüberliegenden Hohlleiterwand 8 in den Hohlleiter 1 hinein und geht mit dem Gehäuse der Diode 2 einen elektrischen Kontakt ein. An seinem diodenseitigen Ende ist der Koppelstift 6 mit einem Querschnittsprung 9 versehen, welcher einen Resonanzkreis bildet. Dieser Querschnittsprung 9 kann eine auf den Koppelstift 6 aufgesetzte Scheibe oder einstückig an den Koppelstift 6 angedreht sein. In der Durchführung 7 weist der Koppelstift 6 eine Sperrfilterstruktur 10 (Choke) auf, die verhindert, daß Anteile der Oszillatorenergie durch die Durchführung 7 ausgekoppelt werden.

Um die Oszillatorfrequenz auf einen gewünschten Wert abstimmen zu können, ist ein Abgleichstift 11 vorgesehen, welcher durch die Hohlleiterwand 8 in den Hohlleiter 1 hineinragt, wobei die Eindringtiefe des Abgleichstiftes 11 variierbar ist. Der Abgleichstift 11 ist unter einem spitzen Winkel auf den Koppelstift 6 ausgerichtet. Dadurch kann der Abgleichstift 11 unmittelbar in den oberhalb des Querschnittsprungs 9 liegenden Resonanzraum der Diode 2 eindringen und das elektrische Feld, das sich um die Diode 2 herum ausbreitet, verstimmen. Durch die schräge Anordnung des Abgleichstiftes 11 ist sein Abstand gegenüber dem äußeren Rand des Querschnittsprungs 9 größer als gegenüber dem inneren Bereich. Da aber die Feldkonzentration am äußeren Rand des Querschnittsprungs 9 erheblich größer ist als in seinem inneren Bereich um den Koppelstift 6 herum, hat der Abgleichstift 6 wegen seiner größeren Entfernung zum äußeren Rand und seines geringeren Abstandes gegenüber dem inneren Bereich des Querschnittsprungs 9 einen größeren Einfluß auf das schwächere Feld. Für eine Veränderung der Resonanzfrequenz des Oszillators ist eine größere Änderung der Eindringtiefe des Abgleichstiftes 6 in das schwächere Feld erforderlich als wenn der Abgleichstift 6 primär die höhere Feldkonzentration beeinflussen würde. Hinzu kommt, daß die Feldkonzentration oberhalb des Querschnittsprungs 9 generell geringer ist als unterhalb in der Nähe der Diode 2. Die Abgleichempfindlichkeit für die Resonanzfrequenz des Oszillators wird also mit der beschriebenen Anordnung geringer, was den Abgleichvorgang vereinfacht. Außerdem ist die Abhängigkeit der Resonanzfrequenz von der Eindringtiefe des Abgleichstiftes 6 weitgehend linear.

Der Abgleichstift 11 - vorzugsweise eine Schraube - kann in beliebiger Position rund um den Koppelstift 6 herum zwischen dessen Querschnittssprung 9 und Sperrfilterstruktur 10 ausgerichtet sein. Wenn es für die Fequenzabstimmung erforderlich ist, können auch mehrere Abgleichstifte in der Hohlleiterwand 8 oder auch in der Hohlleiterwand 4 vorgesehen werden.

Eine zusätzliche Abstimmmöglichkeit, vornehmlich für die Leistung des Oszillators, ergibt sich, wenn die Kurzschlußwand des Hohlleiters 1 als Schraube 12 ausgeführt ist, deren Abstand zur Diode veränderbar ist.

## Patentansprüche

1. Mikrowellenoszillator, bestehend aus einem einseitig kurzgeschlossenen Hohlleiter und einer darin angeordneten Diode - vorzugsweise Gunn-Diode -, die ihre Versorgungsspannung über einen durch eine Hohlleiterwand hindurchgeführten Koppelstift erhält, wobei mindestens ein in den Hohlleiter hineinragender, in seiner Eindringtiefe verstellbarer Abgleichstift zum Abstimmen der Oszillatorfrequenz vorgesehen ist, dadurch gekennzeichnet, daß der Abgleichstift (11) unter einem spitzen Winkel auf dem Koppelstift (6) ausgerichtet ist.

2. Mikrowellenoszillator nach Anspruch 1, dadurch gekennzeichnet, daß der Koppelstift (6) im Hohlleiter (1) mit einem Querschnittssprung (9) versehen ist, welcher einen Resonanzkreis bildet, und daß der Koppelstift (6) außerhalb des Hohlleiters (1) eine Sperrfilterstruktur (10) aufweist.

3. Mikrowellenoszillator nach Anspruch 1 oder 2, dadurch gekennzeichnet, daß der Abgleichstift (11) zwischen dem Querschnittssprung (9) und der Sperrfilterstruktur (10) auf den Koppelstift (6) ausgerichtet ist.

4. Mikrowellenoszillator nach Anspruch 1, dadurch gekennzeichnet, daß die Kurzschlußwand (12) des Hohlleiters (1) verschiebbar ist.

## Claims

1. Microwave oscillator comprising a waveguide short-circuited at one end and a diode - preferably a Gunn diode - arranged therein, which obtain their supply voltage via a coupling pin guided through a waveguide wall, at least one tuning pin, which projects into the waveguide and whose depth of penetration can be adjusted, being provided for tuning the oscillator frequency, characterized in that the tuning pin (11) is aligned at an acute angle to the coupling pin (6).

2. Microwave oscillator according to Claim 1, characterized in that the coupling pin (6) is provided in the waveguide (1) with a cross-sectional jump (9) which forms a resonant circuit, and in that the coupling pin (6) has a stop-filter structure (10) outside the waveguide (1).

3. Microwave oscillator according to Claim 1 or 2, characterized in that the tuning pin (11) is aligned between the cross-sectional jump (9) and the stop-filter structure (10) on the coupling pin (6).

4. Microwave oscillator according to Claim 1, characterized in that the short-circuiting wall (12) of the waveguide (1) can be displaced.

## Revendications

1. Oscillateur hyperfréquences composé d'un guide d'ondes dont une extrémité est court-circuitée, logeant une diode (de préférence une diode Gunn) recevant sa tension d'alimentation par une broche de couplage traversant la paroi du guide d'ondes,
au moins une broche de réglage pénétrant dans le guide d'ondes et sa profondeur de pénétration étant réglable pour accorder la fréquence de l'oscillateur,
caractérisé en ce que
la broche de réglage (11) fait un angle aigu par rapport à la broche de couplage (6).

2. Oscillateur hyperfréquences selon la revendication 1,
caractérisé en ce que
la broche de couplage (6) est munie, à l'intérieur du guide d'ondes (1), d'une variation brusque de section (9) formant un circuit résonnant, et la broche de couplage (6) présente, à l'extérieur du guide d'ondes (1), une structure de filtre bloquant (10).

3. Oscillateur selon les revendications 1 ou 2,
caractérisé en ce que
la broche de réglage (11) est alignée, entre la variation brusque de section (9) et la structure de filtre bloquant (10), sur la broche de couplage (6).

4. Oscillateur selon la revendication 1,
caractérisé en ce que
la paroi de court-circuit (12) du guide d'ondes (1) est coulissante.
